# EUROPEAN PATENT APPLICATION

(11) **EP 4 734 493 A1**
(43) Date of publication of application: **29.04.2026**
(21) Application number: 24832344.6
(22) Date of filing: 17.06.2024
(51) Int. Cl.: H04M 1/72454, H04M 1/23, G01R 27/26, H01R 9/05, H05K 1/14, H01Q 1/24, H04B 1/40, G06F 1/16

(54) **ELECTRONIC DEVICE INCLUDING COAXIAL CABLE, OPERATING METHOD THEREOF, AND RECORDING MEDIUM**

(30) Priority: 26.06.2023 KR 20230082012; 08.08.2023 KR 20230103339
(71) Applicant: Samsung Electronics Co., Ltd., Suwon-si, Gyeonggi-do 16677 (KR)
(72) Inventor: KWON, Eunbae, Suwon-si, Gyeonggi-do 16677 (KR); LEE, Heetak, Suwon-si, Gyeonggi-do 16677 (KR); KIM, Jongmin, Suwon-si, Gyeonggi-do 16677 (KR); CHO, Kyonghwan, Suwon-si, Gyeonggi-do 16677 (KR)
(74) Representative: Nederlandsch Octrooibureau
(86) International application number: PCT/KR2024/008303
(87) International publication number: WO 2025/005564

(57) **Abstract**

According to an embodiment, an electronic device may comprise: a first printed circuit board; a second printed circuit board disposed to be spaced apart from the first printed circuit board; a coaxial cable which connects the first printed circuit board and the second printed circuit board to transmit an RF signal; a first grip sensor connected to a shield part included in the coaxial cable; and a processor, wherein the processor identifies the amount of capacitance change of the shield part through the first grip sensor. Various other embodiments are possible.

## Description

### [Technical Field]

Embodiments of the disclosure relate to an electronic device including a coaxial cable, an operation method therefor, and a recording medium.

### [Background Art]

Electronic devices may include an element that electrically connects individual electronic components arranged to be spaced apart to implement various functions. Through this, electronic components arranged within the electronic device may be electrically connected.

As an example, the electronic device may include a coaxial cable electrically connecting two electronic components (e.g., printed circuit boards). For example, a connector installed at an end of the coaxial cable may physically contact a receptacle disposed in each electronic component and electrically connect two electronic components, and the electronic device may transmit and/or receive RF signals through the coaxial cable having the above-described structure.

### [Detailed Description of the Invention]

### [Technical Solution]

According to an embodiment, an electronic device may include a first printed circuit board, a second printed circuit board disposed spaced apart from the first printed circuit board, a coaxial cable connecting the first printed circuit board and the second printed circuit board to transmit an RF signal, a first grip sensor connected to a shield part included in the coaxial cable, a processor, and memory that stores instructions.

According to an embodiment, the electronic device may identify the amount of change in capacitance of the shield part through the first grip sensor.

According to an embodiment, in an operation method of an electronic device, the electronic device may include a first printed circuit board, a second printed circuit board disposed spaced apart from the first printed circuit board, a coaxial cable connecting the first printed circuit board and the second printed circuit board to transmit an RF signal, and a first grip sensor connected to a shield part included in the coaxial cable.

According to an embodiment, the operation method of the electronic device may include identifying the amount of change in capacitance of the shield part through the first grip sensor.

According to an embodiment, in a non-transitory recording medium, the electronic device may include a first printed circuit board, a second printed circuit board disposed spaced apart from the first printed circuit board, a coaxial cable connecting the first printed circuit board and the second printed circuit board to transmit an RF signal, and a first grip sensor connected to a shield part included in the coaxial cable.

According to an embodiment, the non-transitory recording medium may store at least one instruction capable of performing an operation of identifying the amount of change in capacitance of the shield part through the first grip sensor.

### [Brief Description of Drawings]

FIG. 1 is a block diagram illustrating an electronic device 101 in a network environment 100 according to various embodiments.
FIG. 2 is a diagram illustrating a case where a user grips an electronic device according to a comparative embodiment.
FIG. 3A is a diagram illustrating a portion a rear face of an electronic device according to a comparative embodiment.
FIG. 3B is a diagram illustrating the structure of a coaxial cable according to an embodiment.
FIG. 4A is a diagram illustrating a portion of a rear face of an electronic device according to an embodiment.
FIG. 4B is a diagram illustrating a first circuit according to an embodiment.
FIG. 5A is a diagram illustrating a portion of a rear face of an electronic device according to an embodiment.
FIG. 5B is a diagram illustrating a second circuit according to an embodiment.
FIG. 6 is a flowchart illustrating an operation in which the electronic device described in FIGS. 4A and 4B identifies whether the electronic device is gripped according to an embodiment.
FIG. 7 is a flowchart illustrating an operation in which the electronic device described in FIGS. 5A and 5B identifies whether the electronic device is gripped according to an embodiment.
FIG. 8A is a diagram illustrating an operation in which an electronic device identifies a grip on a side part of the electronic device according to an embodiment.
FIG. 8B is a diagram illustrating an operation in which an electronic device identifies a grip on a side part of the electronic device according to an embodiment.
FIG. 9A is a diagram illustrating an operation in which an electronic device identifies a grip state of the electronic device in portrait mode according to an embodiment.
FIG. 9B is a diagram illustrating an operation in which an electronic device identifies a grip state of the electronic device in portrait mode according to an embodiment.
FIG. 10A is a flowchart illustrating an operation in which an electronic device does not adjust the size of a slidable display when the electronic device is gripped according to an embodiment.
FIG. 10B is a flowchart illustrating an operation in which an electronic device adjusts the size of a slidable display according to an embodiment.
FIG. 11A is a diagram illustrating an operation in which an electronic device does not adjust the size of a slidable display when the electronic device is gripped according to an embodiment.
FIG. 11B is a diagram illustrating an operation in which an electronic device adjusts the size of a slidable display according to an embodiment.
FIG. 12 is a flowchart illustrating an operation in which an electronic device identifies whether a stylus pen is inserted into the electronic device according to an embodiment.

### [Mode for Carrying out the Invention]

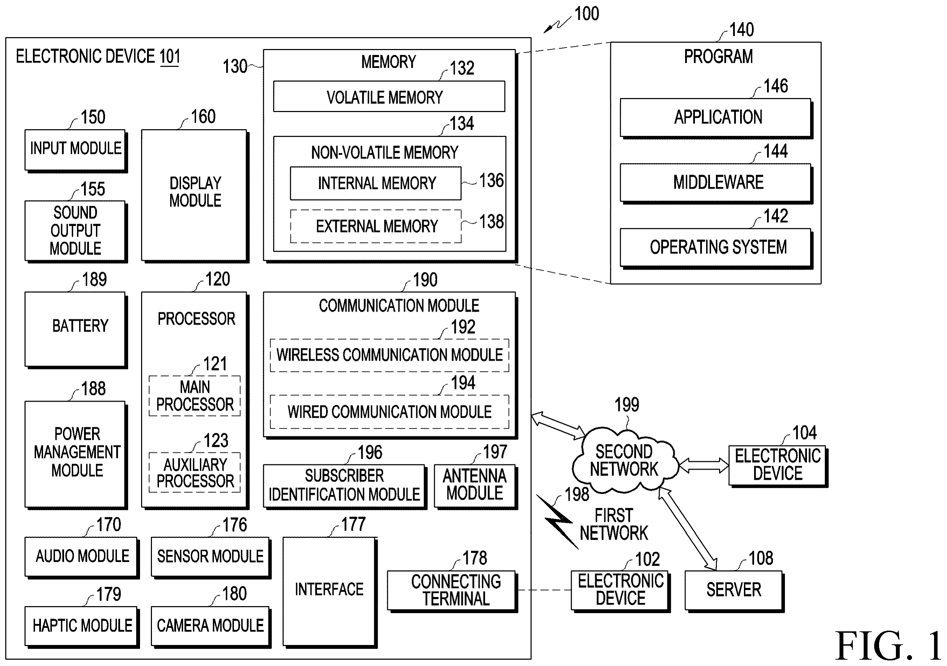

FIG. 1 is a block diagram illustrating an electronic device 101 in a network environment 100 according to various embodiments. Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

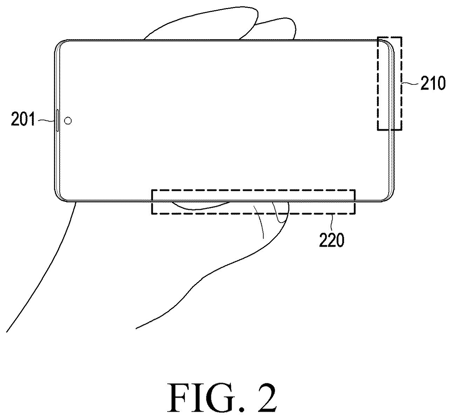

FIG. 2 is a diagram illustrating an operation of identifying a user's grip on a conventional electronic device according to a comparative embodiment.

Referring to FIG. 2, according to the comparative embodiment, the electronic device 201 may identify whether a user (e.g., a user's hand) is gripping the electronic device 201. The electronic device 201 may include a sensor (e.g., a grip sensor) for identifying whether the user is gripping the electronic device 201. The sensor may sense the amount of change in capacitance of a conductor. The electronic device 201 may include an antenna disposed in the lower part 210 of the electronic device 201. For example, the sensor may be electrically connected to an antenna implemented as a conductor. The electronic device 201 may obtain, through a sensor connected to the antenna, a sensing value corresponding to the amount of change in capacitance of the antenna due to the user's grip. The electronic device 201, based on the sensing value corresponding to the amount of change in capacitance of the antenna, may identify whether a user is gripping the lower part 210 of the electronic device 201 and/or the degree of grip. In an embodiment, the electronic device 201 may adjust the signal sensitivity of the antenna disposed on the lower part, based on the grip and/or the degree of grip.

According to the comparative example, the electronic device 201 may not accurately identify whether a user is gripping the side part 220 of the electronic device 201. For example, since the sensor for identifying whether a user is gripping the electronic device is connected to the antenna disposed on the lower part 210 of the electronic device 201, the electronic device 201 may not be able to identify whether a user is gripping the side part 220 of the electronic device 201 and/or the degree of grip.

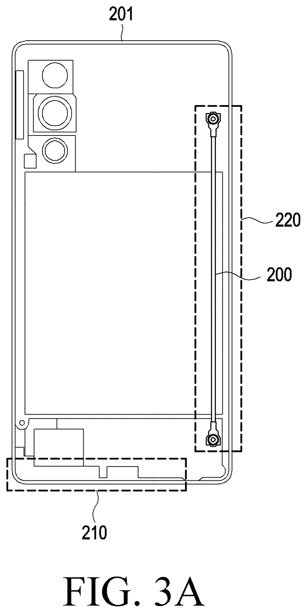

FIG. 3A is a perspective view illustrating the rear face of an electronic device according to a comparative example.

Referring to FIG. 3A, according to a comparative embodiment, an electronic device 201 may include a coaxial cable 200 positioned on a side part of the electronic device 201. The coaxial cable 200 may include a conductor (e.g., a shield part of the coaxial cable).

According to the comparative embodiment, the electronic device 201 may not accurately identify whether a user is gripping the side part 220 of the electronic device 201. According to the comparative embodiment, since a sensor (e.g., a grip sensor) for identifying whether a user is gripping the electronic device is not connected to a conductor positioned on the side part 220 of the electronic device 201, the electronic device 201 may not identify a change in capacitance due to the user gripping the side part 220 of the electronic device 201. Accordingly, the electronic device 201 may not be able to accurately identify whether the user is gripping the side part 220 of the electronic device 201 and/or the degree of grip.

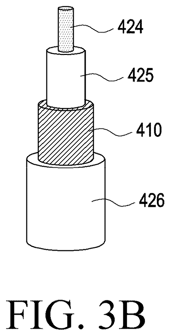

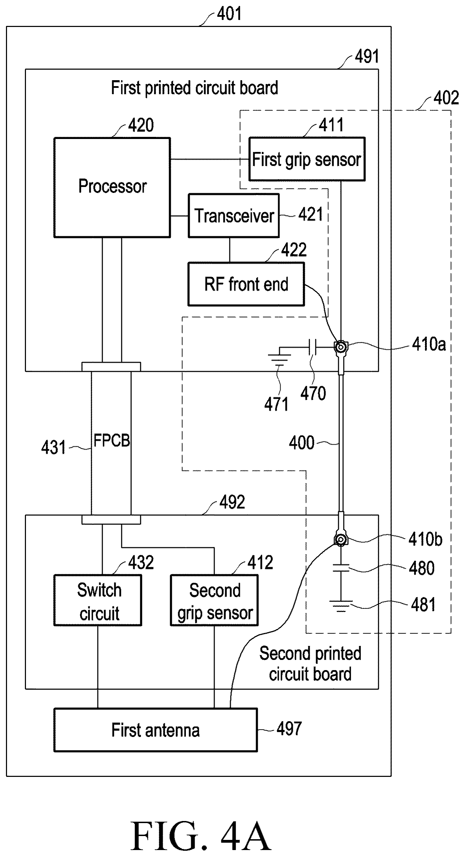

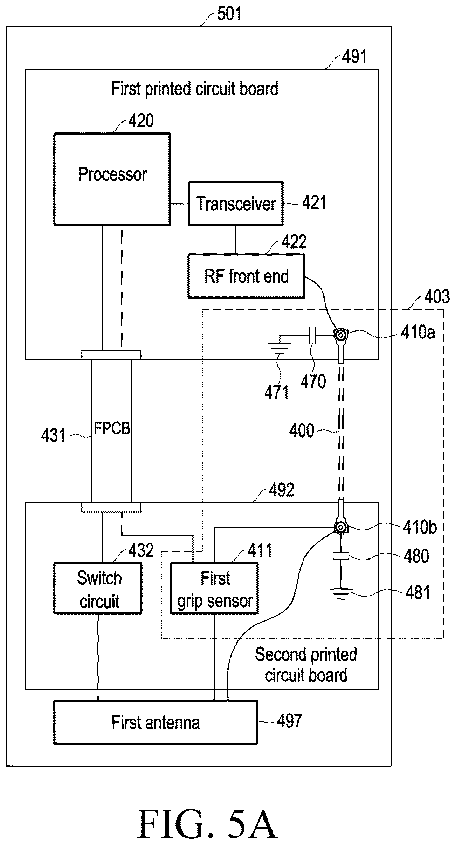

An electronic device 401 or 501 according to an embodiment of the disclosure may connect a conductor (e.g., a shield part 410 of a coaxial cable) included in a coaxial cable (e.g., 400 in FIG. 3B) and a sensor (e.g., the first grip sensor 411 in FIG. 4A or the first grip sensor 411 in FIG. 5A) capable of identifying a user's grip, thereby identifying whether a user is gripping the side part of the electronic device 401 or 501 where the coaxial cable 400 is disposed.

FIG. 3B is a diagram illustrating the structure of a coaxial cable according to an embodiment.

Referring to FIG. 3B, according to an embodiment, the coaxial cable 400 may include a shield part 410, an RF signal line 424, and insulators 425 and 426. According to an embodiment, the RF signal line 424 may be implemented as a conductor. According to an embodiment, the RF signal line 424 may transmit and receive RF signals. According to an embodiment, the insulator 425 may cover the RF signal line and separate the RF signal line 424 from the shield part 410.

According to an embodiment, the shield part 410 may be implemented as a conductor. According to an embodiment, the insulator 426 may cover the shield part 410. According to an embodiment, when an external object approaches the shield part 410, the capacitance of the shield part 410 may change.

According to an embodiment, the shield part 410 may be electrically connected to a sensor (e.g., the first grip sensor 411 in FIG. 4A or the first grip sensor 411 in FIG. 5A) capable of identifying whether a user is gripping the electronic device. According to an embodiment, the sensor capable of identifying whether a user is gripping the electronic device may obtain a change in capacitance of the shield part 410.

FIG. 4A is a diagram illustrating a portion of a rear face of an electronic device according to an embodiment.

Referring to FIG. 4A, according to an embodiment, the electronic device 401 may include a first printed circuit board 491, a second printed circuit board 492, a processor 420, a transceiver 421, a flexible printed circuit board (FPCB) 431, an RF front end 422, a first antenna 497, a switch circuit 432, a second grip sensor 412, and/or a first circuit 402. According to an embodiment, the first circuit 402 may include a first grip sensor 411, a first capacitor 470, a second capacitor 480, and a coaxial cable 400. However, this is merely an example, and embodiments of the disclosure may further include various components or exclude at least one of the above components. According to an embodiment, the electronic device 401 may be implemented identically or similarly to the electronic device 101 in FIG. 1.

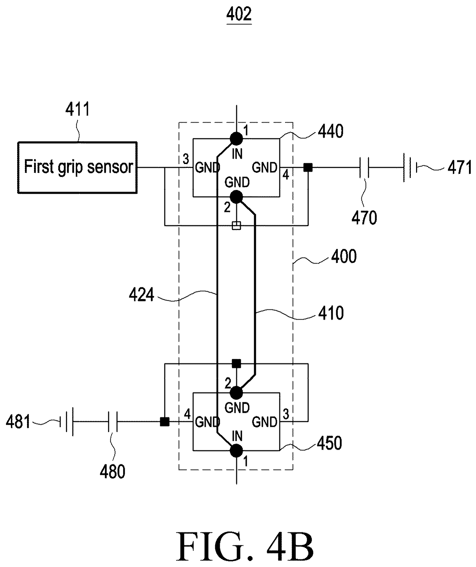

According to an embodiment, the processor 420, the first grip sensor 411, the transceiver 421, the RF front end 422, and the first capacitor 470 may be disposed on the first printed circuit board 491. According to an embodiment, the second grip sensor 412, the switch circuit 432, and the second capacitor 480 may be disposed on the second printed circuit board 492. According to an embodiment, a first receptacle 440 (e.g., the first receptacle 440 in FIG. 4B) to which one end 410a of the coaxial cable 400 may be connected may be disposed on the first printed circuit board 491.

According to an embodiment, a second receptacle 450 (e.g., the second receptacle 450 in FIG. 4B) to which the other end 410b of the coaxial cable 400 may be connected may be disposed on the second printed circuit board 492.

According to an embodiment, some of the components disposed on the first printed circuit board 491 may be disposed on the second printed circuit board 492, and some of the components disposed on the second printed circuit board 492 may be disposed on the first printed circuit board 491. According to an embodiment, the first printed circuit board 491 may refer to a board positioned on one end (e.g., the upper part) of the electronic device 401, and the second printed circuit board 492 may refer to a board positioned on the other end (e.g., the lower part) of the electronic device 401. However, this is merely an example, and the positions where the first printed circuit board 491 and the second printed circuit board 492 are positioned in the electronic device 401 may not be limited thereto.

According to an embodiment, the processor 420 may control the overall operation of the electronic device 401. According to an embodiment, the processor 420 may include an application processor or a communication processor. For example, the processor 420 may be implemented in a manner identical to or similar to the processor 120 in FIG. 1. According to an embodiment, the processor 420 may be connected to the first grip sensor 411 and the transceiver 421. According to an embodiment, the processor 420 may be connected to the switch circuit 432 and the second grip sensor 412 via the FPCB 431.

According to an embodiment, the first grip sensor 411 and the second grip sensor 412 may sense the amount of change in capacitance for a conductor. Each of the first grip sensor 411 and the second grip sensor 412 may provide the processor 420 with a sensing value corresponding to the sensed amount of change in capacitance.

According to an embodiment, the second printed circuit board 492 may be disposed spaced apart from the first printed circuit board 491. According to an embodiment, the coaxial cable 400 may connect the first printed circuit board 491 and the second printed circuit board 492 to transmit and/or receive RF signals. According to an embodiment, one end 410a of the coaxial cable 400 may be connected to the RF front end 422, and the other end 410b of the coaxial cable 400 may be connected to the first antenna 497. According to an embodiment, the RF front end 422 may transmit an RF signal to the first antenna 497 or receive an RF signal from the first antenna 497 via the coaxial cable 400 (e.g., the RF signal line 424 in FIG. 4B). According to an embodiment, the coaxial cable 400 may be disposed between the first printed circuit board 491 and the second printed circuit board 492. For example, the coaxial cable 400 may be disposed close to a side part (e.g., the side part 220 in FIG. 2) of the electronic device 401.

According to an embodiment, one end 410a of the coaxial cable 400 may be connected to the first receptacle 440 disposed on the first printed circuit board 491. According to an embodiment, the other end 410b of the coaxial cable 400 may be connected to the second receptacle 450 disposed on the second printed circuit board 492.

According to an embodiment, the first capacitor 470 may be disposed between the first receptacle 440 to which one end 410a of the coaxial cable 400 is connected and the ground 471 of the first printed circuit board 491. According to an embodiment, the second capacitor 480 may be disposed between the second receptacle 450 to which the other end 410b of the coaxial cable 400 is connected and the ground 481 of the second printed circuit board 492. According to an embodiment, the first capacitor 470 and the second capacitor 480 may filter out the DC component of the RF signal.

According to an embodiment, the first antenna 497 may be connected to the second grip sensor 412. According to an embodiment, the first antenna 497 may include a radiator implemented as a conductor. According to an embodiment, the processor 420 may identify the amount of change in capacitance of the first antenna 497 including a conductor through the second grip sensor 412.

According to an embodiment, the shield part 410 of the coaxial cable 400 may be electrically connected to the first grip sensor 411 through one end 410a of the coaxial cable 400. The shield part 410 of the coaxial cable 400 may cover a conductive wire (e.g., the RF signal line 424) through which RF signals of the coaxial cable 400 are transmitted and received. For example, the shield part 410 of the coaxial cable 400 may include a conductor. According to an embodiment, the first grip sensor 411 may obtain a sensing value corresponding to the amount of change in capacitance of a conductor connected to the first grip sensor 411.

According to an embodiment, the processor 420 may obtain, through the first grip sensor 411, a first sensing value corresponding to the amount of change in capacitance of a conductor (e.g., the shield part 410 (e.g., the shield part 410 in FIG. 3B)) included in the coaxial cable 400. According to an embodiment, based on the first sensing value, the processor 420 may identify whether a user is gripping the side part of the electronic device 401 where the coaxial cable 400 is disposed. For example, when the first sensing value is identified to be greater than a configured first value, the processor 420 may identify that a user is gripping the side part of the electronic device 401. For example, when the first sensing value is identified to be less than the configured first value, the processor 420 may identify that the user is not gripping the side part of the electronic device 401. For example, the configured first value may refer to a sensing value indicating that a user's grip on the coaxial cable 400 of the electronic device 401 is identified. For example, the configured first value may be automatically configured by the processor 420 or may be configured by the user.

According to an embodiment, the processor 420 may obtain, through the second grip sensor 412, second sensing value corresponding to the amount of change in capacitance of the first antenna 497. According to an embodiment, based on the second sensing value, the processor 420 may identify whether a user is gripping the lower part of the electronic device 401 where the first antenna 497 is disposed. For example, when the second sensing value is identified to be greater than a configured second value, the processor 420 may identify that a user is gripping the lower part of the electronic device 401. For example, when the second sensing value is identified to be less than the configured second value, the processor 420 may identify that a user is not gripping the electronic device 401. For example, the configured second value may refer to a sensing value indicating that a user's grip on the first antenna 497 is identified. For example, the configured second value may be automatically configured by the processor 420 or may be configured by the user.

According to an embodiment, the first antenna 497 may be connected to the switch circuit 432. According to an embodiment, the processor 420 may adjust the sensitivity of a signal with respect to the first antenna 497, based on the first sensing value and the second sensing value. According to an embodiment, the processor 420 may control the switch circuit 432 to adjust the resonant frequency of the first antenna 497, based on the first sensing value and the second sensing value. According to an embodiment, the switch circuit 432 may refer to a circuit that connects at least one capacitor and/or at least one inductor to the first antenna 497. According to an embodiment, the resonant frequency of the first antenna 497 may vary depending on the first sensing value and the second sensing value. According to an embodiment, the processor 420 may control the switch circuit 432 to adjust the varied resonant frequency. For example, the resonant frequency of the first antenna 497 identified when the user is not gripping the electronic device 401 may be a first frequency. The resonant frequency of the first antenna 497 identified when the user is gripping the electronic device 401 may be a second frequency, which is different from the first frequency. The processor 420 may control the switch circuit 432 to connect at least one capacitor and/or inductor to the first antenna 497 to adjust the second frequency to the first frequency.

According to an embodiment, the processor 420 may adjust the transmission power of the RF signal, based on the first sensing value and the second sensing value. According to an embodiment, when it is identified that a user is gripping the lower part or side part of the electronic device 401, the processor 420 may compare the transmission power of the RF signal with a configured value. According to an embodiment, when the transmission power of the RF signal is identified to be less than the configured value, the processor 420 may transmit an RF signal having the transmission power. Depending on the implementation, when the transmission power of the RF signal is identified to be less than the configured value, the processor 420 may transmit an RF signal having the transmission power of the configured value. According to an embodiment, when the transmission power of the RF signal is identified to be greater than the configured value, the processor 420 may transmit an RF signal having a transmission power less than or equal to the configured value. However, this is an example of adjusting the intensity of the transmission power, and embodiments of the disclosure may not be limited thereto. For example, the configured value may be configured by the processor 420 or by a user.

FIG. 4B is a diagram illustrating a first circuit according to an embodiment.

Referring to FIG. 4B, according to an embodiment, the first grip sensor 411 and the first capacitor 470 may be electrically connected to the first receptacle 440. According to an embodiment, the first grip sensor 411 may be electrically connected to the first capacitor 470. According to an embodiment, the first capacitor 470 may be disposed between the first receptacle 440 and the ground 471 of the first printed circuit board 491 (e.g., the first printed circuit board 491 in FIG. 4A). According to an embodiment, the first receptacle 440, the first grip sensor 411, and the first capacitor 470 may be disposed on the first printed circuit board 491.

According to an embodiment, the second capacitor 480 may be electrically connected to the second receptacle 450. According to an embodiment, the second capacitor 480 may be disposed between the second receptacle 450 and the ground 481 of the second printed circuit board 492. According to an embodiment, the second receptacle 450 and the second capacitor 480 may be disposed on the second printed circuit board 492 (e.g., the second printed circuit board 492 in FIG. 4A).

According to an embodiment, the first printed circuit board 491 and the second printed circuit board 492 may be disposed spaced apart from each other and connected via the coaxial cable 400.

According to an embodiment, the coaxial cable 400 may include a connector (not shown), an RF signal line 424, and a shield part 410.

According to an embodiment, one end (410a in FIG. 4A) of the coaxial cable 400 and the other end (410b in FIG. 4A) of the coaxial cable 400 may include a connector. According to an embodiment, one end 410a of the coaxial cable 400 may be coupled to the first receptacle 440. According to an embodiment, the other end 410b of the coaxial cable 400 may be coupled to the second receptacle 450.

According to an embodiment, the RF signal line 424 may transmit an RF signal to the first antenna 497 or to the RF front end 422. According to an embodiment, the RF signal line 424 and the shield part 410 may be connected to the first receptacle 440 and the second receptacle 450. According to an embodiment, the shield part 410 may include a conductor. According to an embodiment, when an external object (e.g., a user's hand or finger) approaches the shield part 410, the capacitance value of the shield part 410 may change.

According to an embodiment, the first grip sensor 411 and the first capacitor 470 may be electrically connected to the second capacitor 480 via the shield part 410 of the coaxial cable 400.

According to an embodiment, the processor 420 (e.g., the processor 420 in FIG. 4A) may obtain a first sensing value corresponding to the amount of change in capacitance of the shield part 410 through the first grip sensor 411. According to an embodiment, the processor 420 may identify whether a user is gripping the side part of the electronic device 401 adjacent to the coaxial cable 400, based on the first sensing value.

According to an embodiment, the processor 420 may obtain a second sensing value corresponding to the amount of change in capacitance for the first antenna 497 through the second grip sensor 412 (e.g., the second grip sensor 412 in FIG. 4A). According to an embodiment, the processor 420 may identify whether a user is gripping the lower part of the electronic device 401, based on the second sensing value.

Conventionally, a grip sensor that identifies the amount of change in capacitance of a conductor is connected to an antenna disposed on the lower part of the electronic device 201, and the grip sensor is not connected to a coaxial cable disposed on the side part of the electronic device 201. Conventionally, the electronic device 201 could not identify whether a user is gripping the side part of the electronic device 201, but could only identify whether a user is gripping the lower part of the electronic device 201.

According to an embodiment, the second grip sensor 412 may be connected to the first antenna 497 disposed on the lower part of the electronic device 401. According to an embodiment, the first grip sensor 411 may be connected to the shield part 410 of the coaxial cable 400 disposed on the side part of the electronic device 401. According to an embodiment, the first capacitor 470 may be disposed between the first receptacle 440 and the ground 471 of the first printed circuit board 491. According to an embodiment, the second capacitor 480 may be disposed between the second receptacle 450 and the ground 481 of the second printed circuit board 492. Through this, the electronic device 401 may identify a sensing value corresponding to the amount of change in capacitance of the shield part 410 through the first grip sensor 411, and identify whether the side part of the electronic device 401 is gripped based on the sensing value.

FIG. 5A is a diagram illustrating a portion of a rear face of an electronic device according to an embodiment.

Referring to FIG. 5A, according to an embodiment, an electronic device 501 may include a single grip sensor (e.g., a first grip sensor 411), compared to the electronic device 401 in FIG. 4A.

According to an embodiment, the electronic device 501 may not include an additional grip sensor (e.g., a second grip sensor 412). For example, compared to FIG. 4A, the additional grip sensor may not be disposed on the first printed circuit board 491. Furthermore, the first grip sensor 411 may be disposed on the second printed circuit board 492.

According to an embodiment, the first grip sensor 411 may be connected to the shield part 410 of the coaxial cable 400 and the first antenna 497 via the other end 410b of the coaxial cable 400. According to an embodiment, the processor 420 may identify the amount of change in capacitance of a conductor (e.g., the shield part 410) included in the coaxial cable 400 through the first grip sensor 411. Furthermore, the processor 420 may identify the amount of change in capacitance of the first antenna 497 through the first grip sensor 411.

According to an embodiment, the processor 420 may control the overall operation of the electronic device 501.

According to an embodiment, the processor 420 may obtain, through the first grip sensor 411, a third sensing value corresponding to the amount of change in capacitance of the shield part 410 included in the coaxial cable 400 disposed on the side part of the electronic device 501. According to an embodiment, based on the third sensing value, the processor 420 may identify whether a user is gripping the side part of the electronic device 501. For example, when the third sensing value is identified to be greater than a configured third value, the processor 420 may identify that a user is gripping the side part of the electronic device 501. For example, when the third sensing value is identified to be less than the configured third value, the processor 420 may identify that a user is not gripping the side part of the electronic device 501. For example, the configured third value may refer to a sensing value indicating that a user's grip on the coaxial cable 400 disposed on the side part of the electronic device 501 is identified. For example, the configured third value may be automatically configured by the processor 420, or may be configured by the user.

According to an embodiment, the processor 420 may obtain, through the first grip sensor 411, fourth sensing value corresponding to the amount of change in capacitance of the first antenna 497. According to an embodiment, based on the fourth sensing value, the processor 420 may identify whether the user is gripping the lower part of the electronic device 501. For example, when the fourth sensing value is identified to be greater than a configured fourth value, the processor 420 may identify that a user is gripping the lower part of the electronic device 501. For example, when the fourth sensing value is identified to be less than the configured fourth value, the processor 420 may identify that a user is not gripping the lower part of the electronic device 501. For example, the configured fourth value may refer to a sensing value indicating that a user's grip on the first antenna 497 positioned on the lower part of the electronic device 501 is identified. For example, the configured fourth value may be automatically configured by the processor 420, or may be configured by the user.

According to an embodiment, the first antenna 497 may be connected to the switch circuit 432. According to an embodiment, the processor 420 may adjust the sensitivity of a signal with respect to the first antenna 497, based on the third sensing value and the fourth sensing value. According to an embodiment, the processor 420 may control the switch circuit 432 to adjust the resonant frequency of the first antenna 497, based on the third sensing value and/or the fourth sensing value. According to an embodiment, the switch circuit 432 may refer to a circuit that connects at least one capacitor and/or inductor to the first antenna 497. According to an embodiment, the resonant frequency of the first antenna 497 may vary depending on the third sensing value and/or the fourth sensing value. According to an embodiment, the processor 420 may control the switch circuit 432 to adjust the varied resonant frequency. For example, the resonant frequency of the first antenna 497 detected when a user is not gripping the electronic device 501 may be a third frequency. The resonant frequency of the first antenna 497 detected when a user is gripping the electronic device 501 may be a fourth frequency, which is different from the third frequency. The processor 420 may control the switch circuit 432 to connect at least one capacitor and/or inductor to the first antenna 497, thereby adjusting the fourth frequency to the third frequency.

According to an embodiment, the processor 420 may adjust the transmission power of an RF signal, based on the third sensing value and the fourth sensing value. According to an embodiment, when it is identified that a user is gripping the lower part or side part of the electronic device 501, the processor 420 may compare the transmission power of the RF signal with a configured value. According to an embodiment, when the transmission power of the RF signal is identified to be less than the configured value, the processor 420 may transmit an RF signal having the transmission power. Depending on the implementation, when the transmission power of the RF signal is identified to be less than the configured value, the processor 420 may transmit an RF signal having a transmission power of a preconfigured value. According to an embodiment, when the transmission power of the RF signal is identified to be greater than the configured value, the processor 420 may transmit an RF signal having a transmission power less than the configured value. However, this is only one example of adjusting the intensity of the transmission power, and embodiments of the disclosure may not be limited thereto. For example, the configured value may be configured by the processor 420 or by a user.

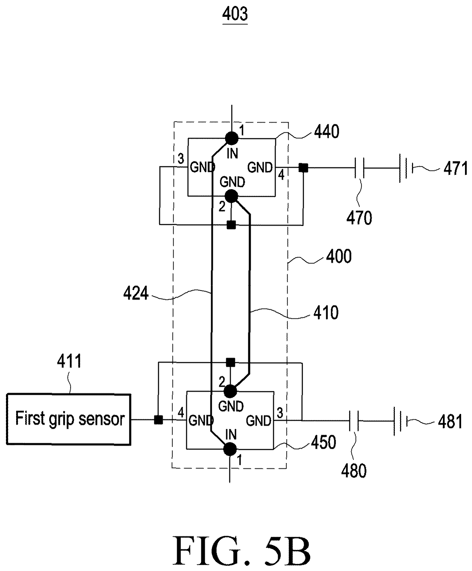

FIG. 5B is a diagram illustrating a second circuit according to an embodiment.

Referring to FIG. 5B, according to an embodiment, comparing a second circuit 403 with the first circuit 402, the first grip sensor 411 may be connected to the second receptacle 450 disposed on the second printed circuit board 492 (e.g., the second printed circuit board 492 in FIG. 5A). Furthermore, according to an embodiment, the first grip sensor 411 may be connected to the second capacitor 480 disposed between the second receptacle 450 and the ground 481 of the second printed circuit board 492.

According to an embodiment, the first grip sensor 411 may be connected to the shield part 410 of the coaxial cable 400 positioned on the side part of the electronic device 501 and the first antenna 497 positioned on the lower part of the electronic device 501.

According to an embodiment, the processor 420 (e.g., the processor 420 in FIG. 5A) may obtain a third sensing value corresponding to the amount of change in capacitance of the shield part 410 through the first grip sensor 411. According to an embodiment, the processor 420 may identify whether a user is gripping the side part of the electronic device 501, based on the third sensing value.

According to an embodiment, the processor 420 may obtain a fourth sensing value corresponding to the amount of change in capacitance of the first antenna 497 through the first grip sensor 411. According to an embodiment, the processor 420 may identify whether a user is gripping the lower part of the electronic device 501, based on the fourth sensing value. For example, when the fourth sensing value is identified to be greater than a configured fourth value, the processor 420 may identify a user is gripping the lower part of the electronic device 501.

Conventionally, a grip sensor that identifies the amount of change in capacitance of a conductor is connected to an antenna disposed on the lower part of the electronic device 201, and the grip sensor is not connected to a coaxial cable disposed on the side part of the electronic device 201. Conventionally, the electronic device 201 could not identify whether a user is gripping the side part of the electronic device 201, but could only identify whether a user is gripping the lower part of the electronic device 201.

According to an embodiment, the first grip sensor 411 may be connected to the first antenna 497 disposed on the lower part of the electronic device 501. According to an embodiment, the first grip sensor 411 may be connected to the shield part 410 of the coaxial cable 400 disposed on the side part of the electronic device 501. According to an embodiment, the second capacitor 480 may be disposed between the second receptacle 450 and the ground 481 of the second printed circuit board 492. Through this, the electronic device 501 may identify a sensing value corresponding to the amount of change in capacitance of the shield part 410 through the first grip sensor 411 and, based on the sensing value, identify whether the side part of the electronic device 501 is gripped.

Operations of the electronic device 401 or 501 described in the drawings below may be performed by the processor 420. However, for convenience of explanation, the operations performed by the processor 420 will be described as being performed by the electronic device 401 or 501.

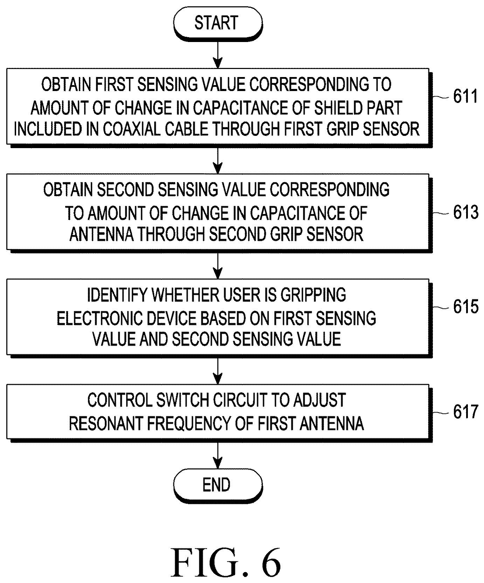

FIG. 6 is a flowchart illustrating an operation in which the electronic device described in FIGS. 4A and 4B identifies whether the electronic device is gripped according to an embodiment.

Referring to FIG. 6, according to an embodiment, in operation 611, an electronic device 401 (e.g., the electronic device 401 in FIG. 4A) may obtain, through a first grip sensor 411 (e.g., the first grip sensor 411 in FIG. 4B), a first sensing value corresponding to the amount of change in capacitance of a shield part 410 (e.g., the shield part 410 in FIG. 4B) included in a coaxial cable 400 (e.g., the coaxial cable 400 in FIG. 4B). According to an embodiment, the first grip sensor 411 may be connected to the shield part 410 of the coaxial cable 400. According to an embodiment, the shield part 410 may include a conductor. According to an embodiment, when an external object (e.g., a user's hand or finger) approaches the shield part 410, the capacitance value of the shield part 410 may change. According to an embodiment, the coaxial cable 400 may be disposed on the side part of the electronic device 401.

According to an embodiment, in operation 613, the electronic device 401 may obtain, through a second grip sensor 412 (e.g., the second grip sensor 412 in FIG. 4A), a second sensing value corresponding to the amount of change in capacitance of a first antenna 497 (e.g., the first antenna 497 in FIG. 4A). According to an embodiment, the second grip sensor 412 may be connected to the first antenna 497. According to an embodiment, the first antenna 497 may be disposed on the lower part of the electronic device 401.

According to an embodiment, in operation 615, the electronic device 401 may identify whether a user is gripping the electronic device 401, based on the first sensing value and/or the second sensing value.

According to an embodiment, when the first sensing value is identified to be greater than a configured first value, the electronic device 401 may identify that a user is gripping the side part of the electronic device 401. According to an embodiment, when the first sensing value is identified to be less than the first value, the electronic device 401 may identify that a user is not gripping the side part of the electronic device 401. According to an embodiment, the first value may refer to a sensing value indicating that a user's grip on the shield part 410 is identified. According to an embodiment, when the second sensing value is identified to be greater than a configured second value, the electronic device 401 may identify that a user is gripping the lower part of the electronic device 401. According to an embodiment, when the second sensing value is identified to be less than the second value, the electronic device 401 may identify that a user is not gripping the lower part of the electronic device 401. According to an embodiment, the second value may refer to a sensing value indicating that a user's grip on the first antenna 497 is identified. For example, the first value and the second value may be automatically configured by the processor 420, or may be configured by the user. According to an embodiment, the first value and the second value may be the same or different values.

According to an embodiment, in operation 617, the electronic device 401 may control a switch circuit 432 (e.g., the switch circuit 432 in FIG. 4A) to adjust the resonant frequency of the first antenna 497. According to an embodiment, the first antenna 497 may be connected to the switch circuit 432. According to an embodiment, the electronic device 401 may control the switch circuit 432 to adjust the resonant frequency of the first antenna 497, based on the first sensing value and the second sensing value. According to an embodiment, the switch circuit 432 may refer to a circuit that connects at least one capacitor and/or at least one inductor to the first antenna 497. According to an embodiment, the resonant frequency of the first antenna 497 may change depending on the amount of change in capacitance of the first antenna 497 and the shield part 410. According to an embodiment, the electronic device 401 may control the switch circuit 432 to adjust the changed resonant frequency. For example, the resonant frequency identified when a user is not gripping the electronic device 401 may be a first frequency. The resonant frequency identified when a user is gripping the electronic device 401 may be a second frequency, which is different from the first frequency. The electronic device 401 may control the switch circuit 432 to connect at least one capacitor and/or at least one inductor to the first antenna 497 to adjust the second frequency to the first frequency.

According to an embodiment, operation 611 may be performed after operation 613, or operations 611 and 613 may be performed simultaneously.

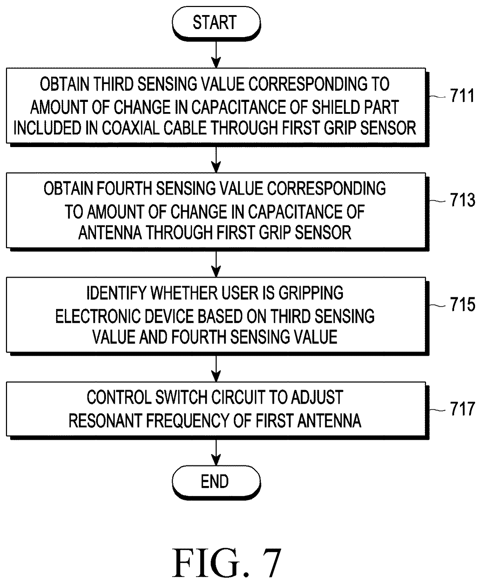

FIG. 7 is a flowchart illustrating an operation in which the electronic device described in FIGS. 5A and 5B identifies whether the electronic device is gripped according to an embodiment.

Referring to FIG. 7, according to an embodiment, in operation 711, an electronic device 501 (e.g., the electronic device 501 in FIG. 5A) may obtain, through a first grip sensor 411 (e.g., the first grip sensor 411 in FIG. 5A), a third sensing value corresponding to the amount of change in capacitance of a shield part 410 (e.g., the shield part 410 in FIG. 5B) included in a coaxial cable 400 (e.g., the coaxial cable 400 in FIG. 5A). According to an embodiment, the first grip sensor 411 may be connected to the shield part 410 of the coaxial cable 400 through the other end 410b of the coaxial cable 400.

According to an embodiment, in operation 713, the electronic device 501 may obtain, through the first grip sensor 411, a fourth sensing value corresponding to the amount of change in capacitance of a first antenna 497 (e.g., the first antenna 497 in FIG. 5B). According to an embodiment, the first antenna 497 may be implemented as a conductor. According to an embodiment, the first grip sensor 411 may be connected to the first antenna 497. According to an embodiment, the first antenna 497 may be disposed on the lower part of the electronic device 501.

According to an embodiment, in operation 715, the electronic device 501 may identify whether a user is gripping the electronic device 501, based on the third sensing value and the fourth sensing value.

According to an embodiment, when the third sensing value is identified to be greater than a configured third value, the electronic device 501 may identify that a user is gripping the side part of the electronic device 501. According to an embodiment, when the third sensing value is identified to be less than the third value, the electronic device 501 may identify that a user is not gripping the side part of the electronic device 501. According to an embodiment, the third value may refer to a sensing value indicating that a user's grip on the shield part 410 is identified. According to an embodiment, when the fourth sensing value is identified to be greater than a configured fourth value, the electronic device 501 may identify that a user is gripping the lower part of the electronic device 501. According to an embodiment, when the fourth sensing value is identified to be less than the fourth value, the electronic device 501 may identify that a user is not gripping the lower part of the electronic device 501. According to an embodiment, the third value may refer to a sensing value indicating that a user's grip on the shield part 410 is identified. According to an embodiment, the fourth value may refer to a sensing value indicating that a user's grip on the first antenna 497 of the electronic device 501 is identified. For example, the third value and the fourth value may be automatically configured by the processor 420, or may be configured by the user. According to an embodiment, the third value and the fourth value may be the same or different values.

According to an embodiment, in operation 717, the electronic device 501 may control a switch circuit 432 (e.g., the switch circuit 432 in FIG. 5A) to adjust the resonant frequency of the first antenna 497. According to an embodiment, the electronic device 501 may control the switch circuit 432 to adjust the resonant frequency of the first antenna 497, based on the third sensing value and the fourth sensing value. According to an embodiment, the switch circuit 432 may refer to a circuit that connects at least one capacitor and/or at least one inductor to the first antenna 497. According to an embodiment, the resonant frequency of the first antenna 497 may vary depending on the amount of change in capacitance of the first antenna 497 and the shield part 410. According to an embodiment, the electronic device 501 may control the switch circuit 432 to adjust the changed resonant frequency. For example, the resonant frequency identified when a user is not gripping the electronic device 501 may be a third frequency. The resonant frequency identified when a user is gripping the electronic device 501 may be a fourth frequency, which is different from the third frequency. The electronic device 501 may control the switch circuit 432 to connect at least one capacitor and/or at least one inductor to the first antenna 497 to adjust the fourth frequency to the third frequency.

According to an embodiment, operation 711 may be performed after operation 713, or operations 711 and 713 may be performed simultaneously.

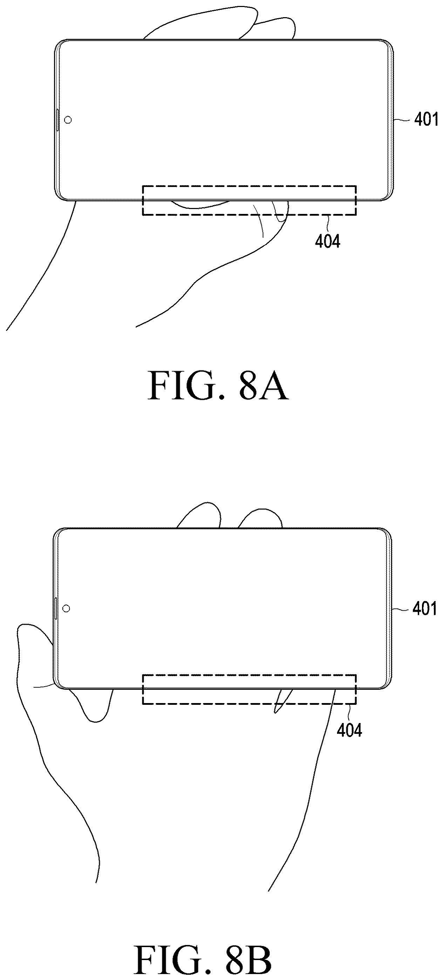

FIGS. 8A and 8B are diagrams illustrating an operation in which an electronic device identifies a grip on a side part of the electronic device according to an embodiment.

Referring to FIGS. 8A and 8B, according to an embodiment, an electronic device 401 or 501 (e.g., the electronic device 401 in FIG. 4A or the electronic device 501 in FIG. 5A) may be gripped by a user's body (e.g., finger and/or palm).

According to an embodiment, a shield part 410 (e.g., the shield part 410 in FIG. 3B) of the coaxial cable 400 may be connected to a first grip sensor 411 (e.g., the first grip sensor 411 in FIG. 4A or the first grip sensor 411 in FIG. 5A).

Through this, according to an embodiment, the electronic device 401 or 501 may sense a change in capacitance of the shield part 410 of the coaxial cable 400 disposed on the side part 404 of the electronic device 401 or 501 through the first grip sensor 411. According to an embodiment, the electronic device 401 or 501 may identify whether the side part 404 of the electronic device 401 or 501 is gripped based on a sensing value corresponding to a change in capacitance of the shield part 410.

According to a comparative embodiment, an electronic device (the electronic device 201 in FIG. 2) may not be able to identify whether a user is gripping the side part 220 of the electronic device 201 because a sensor (e.g., a grip sensor) for identifying whether a user is gripping the electronic device is not connected to the shield part of a coaxial cable 200 (e.g., the coaxial cable 200 in FIG. 2A).

According to an embodiment, the electronic device 401 or 501 may accurately identify whether a user is gripping the side part 404 of the electronic device 201 and/or the degree of grip because the shield part of the coaxial cable 400 disposed on the side part 404 of the electronic device 401 or 501 is connected to the first grip sensor 411.

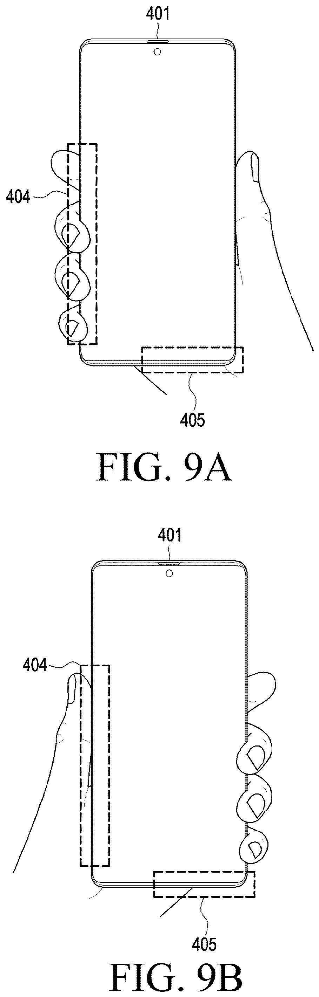

FIG. 9A is a diagram illustrating an operation in which an electronic device identifies a grip state of the electronic device according to an embodiment. FIG. 9B is a diagram illustrating an operation in which an electronic device identifies a grip state of the electronic device according to an embodiment.

Referring to FIGS. 9A and 9B, according to an embodiment, in a case where it is determined that a user is gripping the side part 404 and the lower part 405 of an electronic device 401 or 501 (e.g., the electronic device 401 in FIG. 4A or the electronic device 501 in FIG. 5A) when the electronic device 401 or 501 is in portrait mode, the electronic device 401 or 501 may identify whether the electronic device 401 or 501 is gripped by the user's right hand or left hand.

According to an embodiment, the electronic device 401 may obtain a first sensing value through a first grip sensor 411 (e.g., the first grip sensor 411 in FIG. 4A) and obtain a second sensing value through a second grip sensor 412 (e.g., the second grip sensor 412 in FIG. 4A). According to an embodiment, the electronic device 401 may identify whether the electronic device 401 is gripped by the user's right hand or left hand, based on the first sensing value and the second sensing value.

According to an embodiment, when the first sensing value is identified to be greater than a first value, the electronic device 401 may identify that a user is gripping the side part 404 of the electronic device 401. According to an embodiment, when the second sensing value is identified to be greater than a second value, the electronic device 401 may identify that a user is gripping the lower part 405 of the electronic device 401. For example, the first sensing value may refer to a sensing value corresponding to the amount of change in capacitance of the shield part 410 of the coaxial cable 400, and the second sensing value may refer to a sensing value corresponding to the amount of change in capacitance of the first antenna 497. According to an embodiment, the first value may refer to a value indicating that a grip on the side part 404 of the electronic device 401 is detected, and the second value may refer to a value indicating that a grip on the lower part 405 of the electronic device 401 is detected. For example, the sizes (e.g., 150) of the first value and the second value may be identical. However, this is an example, and the technical concept of the disclosure may not be limited thereto.

According to an embodiment, when the first sensing value is identified to be greater than a fifth value and the second sensing value is identified to be greater than a sixth value, the electronic device 401 may determine that the electronic device 401 is gripped by the user's right hand. According to an embodiment, when the first sensing value is identified to be greater than the fifth value and the second sensing value is identified not to be greater than the sixth value, the electronic device 401 may determine that the electronic device 401 is gripped by the user's left hand. According to an embodiment, the fifth value may refer to a value equal to or greater than the first value. According to an embodiment, the sixth value may refer to a value greater than the second value. According to an embodiment, the size (e.g., 1800) of the sixth value may be greater than the size (e.g., 150) of the fifth value. Depending on the implementation, the sizes of the fifth value and the sixth value may be configured differently. However, this is merely an example, and the technical concept of the disclosure may not be limited thereto.

According to an embodiment, the electronic device 501 may obtain a third sensing value and a fourth sensing value through the first grip sensor 411 (e.g., the first grip sensor 411 in FIG. 5A).

According to an embodiment, when the third sensing value is identified to be greater than a third value, the electronic device 501 may identify that a user is gripping the side part 404 of the electronic device 501. According to an embodiment, when the fourth sensing value is identified to be greater than a fourth value, the electronic device 501 may identify that a user is gripping the lower part 405 of the electronic device 501. For example, the third sensing value may refer to a sensing value corresponding to the amount of change in capacitance of the shield part 410 included in the coaxial cable 400, and the fourth sensing value may refer to a sensing value corresponding to the amount of change in capacitance of the first antenna 497. According to an embodiment, the third value may refer to a value indicating that a grip on the side part 404 of the electronic device 501 is identified, and the fourth value may refer to a value indicating that a grip on the lower part 405 of the electronic device 501 is identified. For example, the sizes (e.g., 150) of the third value and the fourth value may be the same. However, this is an example, and the technical concept of the disclosure may not be limited thereto.

According to an embodiment, when the third sensing value is identified to be greater than a seventh value and the fourth sensing value is identified to be greater than an eighth value, the electronic device 501 may determine that the electronic device 501 is gripped by the user's right hand. According to an embodiment, when the third sensing value is identified to be greater than the seventh value and the fourth sensing value identified not to be greater than the eighth value, the electronic device 501 may determine that the electronic device 501 is gripped by the user's left hand. According to an embodiment, the seventh value may refer to a value that is equal to or greater than the third value. According to an embodiment, the eighth value may refer to a value greater than the fourth value. According to an embodiment, the size (e.g., 1800) of the eighth value may be greater than the size (e.g., 150) of the seventh value. Depending on the implementation, the sizes of the seventh value and the eighth value may be configured differently. However, this is an example, and the technical concept of the disclosure may not be limited thereto.

According to a comparative embodiment, an electronic device 201 (e.g., the electronic device 201 in FIG. 2A) may obtain a sensing value according to a grip on the lower part 210 of the electronic device 201. According to the comparative embodiment, the electronic device 201 is unable to identify whether the lower part 210 of the electronic device 201 is gripped by the user's right hand or left hand.

According to an embodiment, the electronic device 401 or 501 may obtain a sensing value according to a grip on the lower part 405 of the electronic device 401 or 501, and obtain a sensing value according to a grip on the side part 404. According to an embodiment, the electronic device 401 or 501 may identify whether the electronic device 401 or 501 is gripped by the user's right hand or left hand, based on the sensing value obtained according to the grip on the lower part 405 and the sensing value obtained according to the grip on the side part 404.

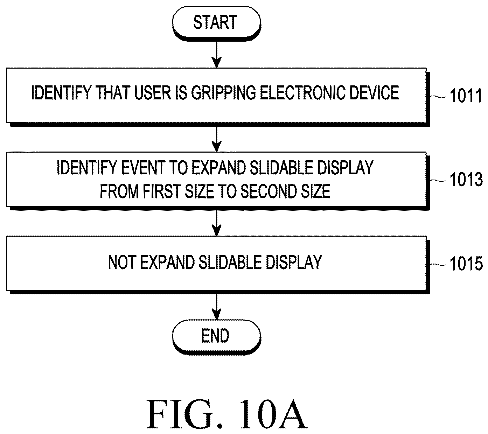

FIG. 10A is a flowchart illustrating an operation in which an electronic device does not adjust the size of a slidable display when the electronic device is gripped according to an embodiment.

Referring to FIG. 10A, according to an embodiment, an electronic device 401 or 501 (e.g., the electronic device 401 in FIG. 4A or the electronic device 401 in FIG. 5A) may be implemented as a slidable electronic device.

According to an embodiment, in operation 1011, the electronic device 401 or 501 may identify that a user is gripping the electronic device 401 or 501.

According to an embodiment, in operation 1013, the electronic device 401 or 501 may identify an event in which a slidable display included in the electronic device 401 or 501 expands from a first size to a second size. According to an embodiment, the event may include a command to expand the size of the slidable display from a first size to a second size. For example, the first size may refer to the current size of the slidable display. For example, the event may include a command to execute an application selected by user input from among a plurality of applications stored in the electronic device 401 or 501. For example, the event may include a command to execute a specific function of the electronic device 401 or 501. For example, the event may include a command to execute specific content (e.g., an image or video). However, this is only one example of the events, and the technical concept of the disclosure may not be limited thereto.

According to an embodiment, in operation 1015, the electronic device 401 or 501 may not expand the slidable display. According to an embodiment, the electronic device 401 or 501 may not expand the slidable display, based on identifying that a user is gripping the electronic device 401 or 501. According to an embodiment, the electronic device 401 or 501 may not expand the slidable display, based on identifying that a user is gripping the side part of the electronic device 401 or 501. Depending on the implementation, according to an embodiment, the electronic device 401 or 501 may not expand the slidable display, based on identifying that a user is gripping the lower part of the electronic device 401 or 501.

According to an embodiment, the electronic device 401 or 501 may expand the size of the slidable display from the first size to the second size when it is identified that a user is not gripping the electronic device 401 or 501.

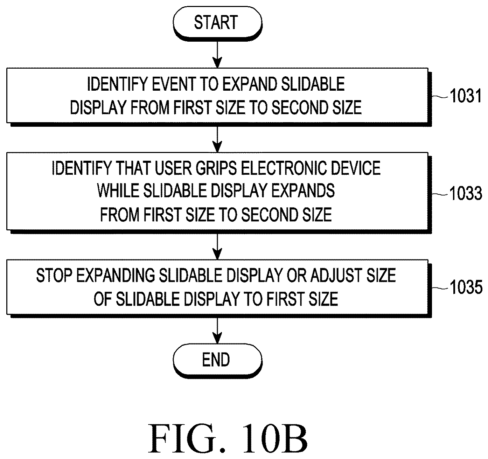

FIG. 10B is a flowchart illustrating an operation in which an electronic device adjusts the size of a slidable display according to an embodiment.

Referring to FIG. 10B, according to an embodiment, an electronic device 401 or 501 (e.g., the electronic device 401 in FIG. 4A or the electronic device 401 in FIG. 5A) may be implemented as a slidable electronic device.

According to an embodiment, in operation 1031, the electronic device 401 or 501 may identify an event in which the slidable display expands from a first size to a second size. According to an embodiment, the event may include a command to expand the size of the slidable display from the first size to the second size. For example, the event may include a command for executing an application selected by user input from among a plurality of applications stored in the electronic device 401 or 501. For example, the event may include a command to execute a specific function of the electronic device 401 or 501. For example, the event may include a command to execute specific content (e.g., an image or video). However, this is only an example, and the technical concept of the disclosure may not be limited thereto.

According to an embodiment, when it is identified that a user is not gripping the electronic device 401 or 501, the electronic device 401 or 501 may expand the size of the slidable display from the first size to the second size. According to an embodiment, when it is identified that a user is not gripping the side part of the electronic device 401 or 501, the electronic device 401 or 501 may expand the size of the slidable display from the first size to the second size. Depending on the implementation, according to an embodiment, when it is identified that a user is not gripping the side part of the electronic device 401 or 501, the electronic device 401 or 501 may expand the size of the slidable display from the first size to the second size.

According to an embodiment, in operation 1033, the electronic device 401 or 501 may identify that a user grips the electronic device 401 or 501 while the slidable display is expanding from the first size to the second size.

According to an embodiment, in operation 1035, based on identifying that the user grips the electronic device 401 or 501 while the slidable display is expanding from the first size to the second size, the electronic device 401 or 501 may stop expanding the slidable display or adjust the size of the slidable display to the first size. According to an embodiment, the electronic device 401 or 501 may stop expanding the slidable display or adjust the size of the slidable display to the first size, based on identifying that a user grips the side part of the electronic device 401 or 501. According to an embodiment, the electronic device 401 or 501 may stop expanding the slidable display or adjust the size of the slidable display to the first size, based on the identifying that a user grips the lower part of the electronic device 401 or 501.

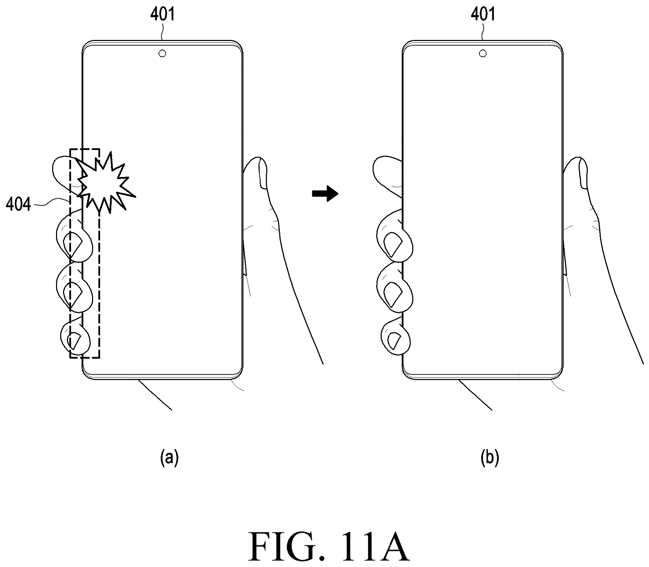

FIG. 11A is a diagram illustrating an operation in which an electronic device does not adjust the size of a slidable display when the electronic device is gripped according to an embodiment.

Referring to (a) in FIG. 11A, according to an embodiment, an electronic device 401 or 501 (e.g., the electronic device 401 in FIG. 4A or the electronic device 401 in FIG. 5A) may identify that a user is gripping the side part 404 of the electronic device 401.

According to an embodiment, the electronic device 401 or 501 may identify an event in which the slidable display included in the electronic device 401 or 501 expands from a first size to a second size. According to an embodiment, the event may include a command to expand the size of the slidable display from a first size to a second size. For example, the first size may refer to the current size of the slidable display. For example, the event may include a command to execute an application selected by user input from among a plurality of applications stored in the electronic device 401 or 501. For example, the event may include a command to execute a specific function of the electronic device 401 or 501. For example, the event may include a command to execute specific content (e.g., an image or video).

Referring to (b) in FIG. 11A, according to an embodiment, the electronic device 401 or 501 may not expand the slidable display, based on identifying that a user grips the side part 404 of the electronic device 401 or 501.

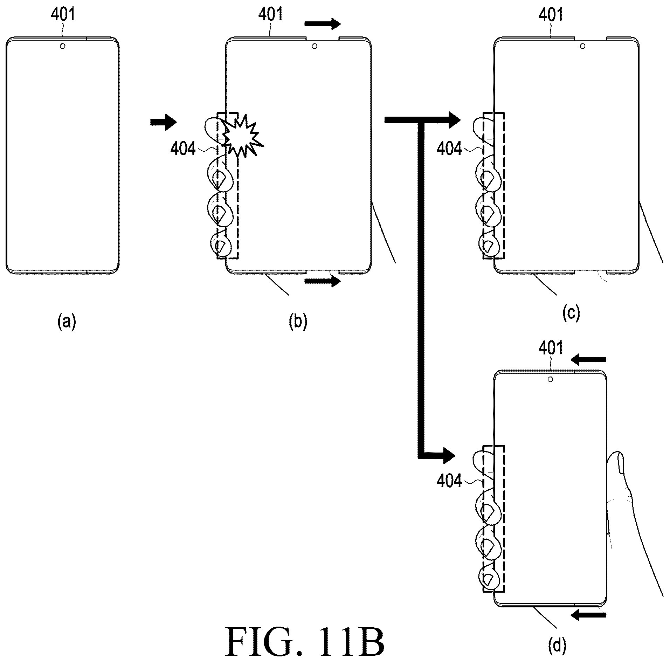

FIG. 11B is a diagram illustrating an operation in which an electronic device adjusts the size of a slidable display according to an embodiment.

Referring to (a) in FIG. 11B, according to an embodiment, an electronic device 401 or 501 (e.g., the electronic device 401 in FIG. 4A or the electronic device 401 in FIG. 5A) may identify an event in which the slidable display expands from a first size to a second size. According to an embodiment, the event may include a command to expand the size of the slidable display from the first size to the second size.

Referring to (b) in FIG. 11B, according to an embodiment, the electronic device 401 or 501 may identify that a user grips the side part 404 of the electronic device 401 or 501 while the slidable display is expanding from the first size to the second size based on the event.

Referring to (c) in FIG. 11B, according to an embodiment, when it is identified that a user grips the side part 404 of the electronic device 401 or 501, the electronic device 401 or 501 may stop expanding the slidable display.

Alternatively, referring to (d) in FIG. 11B, according to an embodiment, when it is identified that a user grips the side part 404 of the electronic device 401 or 501, the electronic device 401 or 501 may adjust the size of the slidable display to the first size.

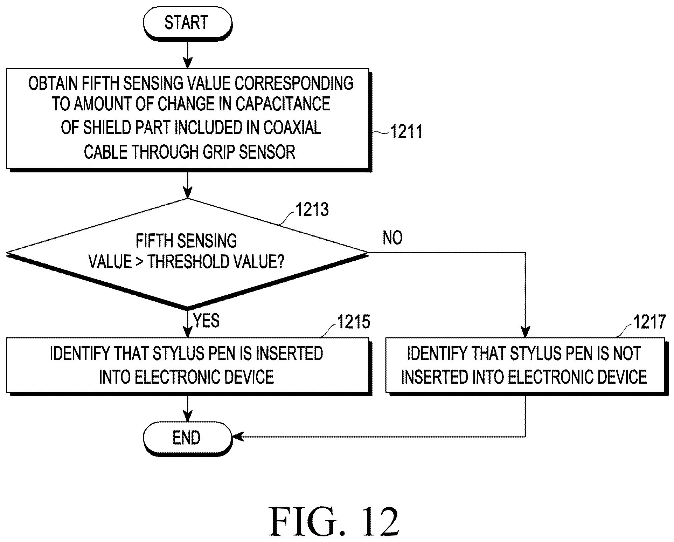

FIG. 12 is a flowchart illustrating an operation in which an electronic device identifies whether a stylus pen is inserted into the electronic device according to an embodiment.

Referring to FIG. 12, according to an embodiment, in operation 1211, an electronic device 401 or 501 (e.g., the electronic device 401 in FIG. 4A or the electronic device 501 in FIG. 5A) may obtain a fifth sensing value corresponding to the amount of change in capacitance of the shield part 410 included in the coaxial cable 400 through a grip sensor. According to an embodiment, the grip sensor may be connected to the coaxial cable 400. According to an embodiment, the electronic device 401 or 501 may identify whether a stylus pen is inserted into the electronic device 401 or 501, based on the fifth sensing value. According to an embodiment, the grip sensor may be a first grip sensor 411 (e.g., the first grip sensor 411 in FIG. 4A or the first grip sensor 411 in FIG. 5A) or a second grip sensor 412 (e.g., the second grip sensor 412 in FIG. 4A). However, this is merely an example, and the grip sensor may be a grip sensor other than the first grip sensor 411 and the second grip sensor 412. According to an embodiment, the stylus pen may be inserted in the vicinity of the position where the coaxial cable 400 is disposed.

According to an embodiment, in operation 1213, the electronic device 401 or 501 may identify whether the fifth sensing value is greater than a threshold value. According to an embodiment, the threshold value may refer to a sensing value indicating that a stylus pen is identified to be inserted into the electronic device 401 or 501.

According to an embodiment, when the fifth sensing value is identified to be greater than the threshold value (Yes in operation 1213), the electronic device 401 or 501 may identify that the stylus pen is inserted into the electronic device 401 or 501 in operation 1215.

According to an embodiment, when the fifth sensing value is identified not to be greater than the threshold value (No in operation 1213), the electronic device 401 or 501 may identify that the stylus pen is not inserted into the electronic device 401 or 501 in operation 1217.

According to an embodiment, the electronic device 401 or 501 may include a first printed circuit board 491, a second printed circuit board 492 disposed spaced apart from the first printed circuit board 491, a coaxial cable 400 connecting the first printed circuit board 491 and the second printed circuit board 492 to transmit an RF signal, a first grip sensor 411 connected to a shield part 410 included in the coaxial cable 400, and a processor 420.

According to an embodiment, the electronic device 401 or 501 may identify the amount of change in capacitance of the shield part through the first grip sensor 411.

According to an embodiment, the electronic device 401 or 501 may identify whether a user is gripping the electronic device 401 or 501, based on the amount of change in capacitance of the shield part 410.

According to an embodiment, the electronic device 401 or 501 may include a first receptacle 440 disposed on the first printed circuit board 491 and connected to one end of the coaxial cable 400.

According to an embodiment, the electronic device 401 or 501 may include a second receptacle 450 disposed on the second printed circuit board 492 and connected to the other end of the coaxial cable 400.

According to an embodiment, the electronic device 401 or 501 may include a first capacitor 470 disposed between the first receptacle 440 and the ground 471 of the first printed circuit board 491.

According to an embodiment, the electronic device 401 or 501 may include a second capacitor 480 disposed between the second receptacle 450 and the ground 481 of the second printed circuit board 492.

According to an embodiment, the electronic device 401 or 501 may include a first antenna 497 connected to the second receptacle 450.

According to an embodiment, the electronic device 401 may include a second grip sensor 412 disposed on the second printed circuit board 492 and connected to the first antenna 497.

According to an embodiment, the first grip sensor 411 of the electronic device 401 may be disposed on the first printed circuit board 491 and connected to the first receptacle and the first capacitor 470.

According to an embodiment, the electronic device 401 may identify whether a user is gripping the side part of the electronic device 401, based on a first sensing value corresponding to the amount of change in capacitance of the coaxial cable 400 obtained through the first grip sensor 411.

According to an embodiment, the electronic device 401 may identify whether a user is gripping the lower part of the electronic device 401, based on a second sensing value corresponding to the amount of change in capacitance of the first antenna 497 obtained through the second grip sensor.

According to an embodiment, the electronic device 401 may include a switch circuit 432 configured to connect the first antenna 497 to at least one capacitor or inductor.

According to an embodiment, the electronic device 401 may control the switch circuit 432 to adjust the resonant frequency of the first antenna 497, based on the first sensing value and the second sensing value.

According to an embodiment, the electronic device 401 may include a first antenna 497 connected to the second receptacle 450.

According to an embodiment, the first grip sensor 411 of the electronic device 501 may be disposed the second printed circuit board 492 and connected to the first antenna 497.

According to an embodiment, the electronic device 501 may identify whether a user is gripping the side part of the electronic device 501, based on a third sensing value corresponding to the amount of change in capacitance of the coaxial cable 400 obtained through the first grip sensor 411.

According to an embodiment, the electronic device 501 may identify whether a user is gripping the lower part of the electronic device 501, based on a fourth sensing value corresponding to the amount of change in capacitance of the first antenna 497 obtained through the first grip sensor 411.

According to an embodiment, the electronic device 401 or 501 may include a switch circuit 432 configured to connect the first antenna 497 to at least one capacitor or inductor.

According to an embodiment, the electronic device 501 may control the switch circuit 432 to adjust the resonant frequency of the first antenna 497, based on the third sensing value and the fourth sensing value.

According to an embodiment, the electronic device 401 may determine whether the electronic device 401 is gripped by the user's left or right hand, based on the first sensing value and the second sensing value.

According to an embodiment, the electronic device 401 or 501 may adjust the transmission power of the RF signal, based on the amount of change in capacitance.

According to an embodiment, in an operation method of an electronic device 401 or 501, the electronic device 401 or 501 may include a first printed circuit board 491, a second printed circuit board 492 disposed spaced apart from the first printed circuit board 491, a coaxial cable 400 connecting the first printed circuit board 491 and the second printed circuit board 492 to transmit an RF signal, and a first grip sensor 411 connected to a shield part 410 included in the coaxial cable 400.

According to an embodiment, the operation method of the electronic device 401 or 501 may include identifying the amount of change in capacitance of the shield part 410 through the first grip sensor 411.

According to an embodiment, the operation method of the electronic device 401 or 501 may include identifying whether a user is gripping the electronic device 401 or 501, based on the amount of change in capacitance of the shield part 410.

According to an embodiment, in the operation method of the electronic device 401 or 501, the electronic device 401 may include a first receptacle 440 disposed on the first printed circuit board 491 and connected to one end of the coaxial cable 400.

According to an embodiment, in the operation method of the electronic device, the electronic device 401 or 501 may include a second receptacle 450 disposed on the second printed circuit board 492 and connected to the other end of the coaxial cable.

According to an embodiment, in the operation method of the electronic device 401 or 501, the electronic device 401 or 501 may include a first capacitor 470 disposed between the first receptacle 440 and the ground of the first printed circuit board 491.

According to an embodiment, in the operation method of the electronic device 401 or 501, the electronic device 401 may include a second capacitor 480 disposed between the second receptacle 450 and the ground of the second printed circuit board 492.

According to an embodiment, in the operation method of the electronic device 401 or 501, the electronic device 401 or 501 may include a first antenna 497 connected to the second receptacle 450.

According to an embodiment, in the operation method of the electronic device 401, the electronic device 401 may include a second grip sensor 412 disposed on the second printed circuit board 492 and connected to the first antenna 497.

According to an embodiment, in the operation method of the electronic device 401, the first grip sensor 411 may be disposed on the first printed circuit board 491 and connected to the first receptacle 440 and the first capacitor 470.

According to an embodiment, the operation method of the electronic device 401 may include identifying whether a user is gripping a side part of the electronic device 401, based on a first sensing value corresponding to the amount of change in capacitance of the coaxial cable obtained through the first grip sensor 411.

According to an embodiment, the operation method of the electronic device 401 may include identifying whether a user is gripping a lower part of the electronic device 401, based on a second sensing value corresponding to the amount of change in capacitance of the first antenna 497 obtained through the second grip sensor 412.

According to an embodiment, in the operation method of the electronic device 401, the electronic device 401 or 501 may include a switch circuit 432 configured to connect the first antenna 497 to at least one capacitor or inductor.

According to an embodiment, the operation method of the electronic device 401 may include controlling the switch circuit 432 to adjust a resonant frequency of the first antenna 497, based on the first sensing value and the second sensing value.

According to an embodiment, in the operation method of the electronic device 401 or 501, the electronic device may include a first antenna 497 connected to the second receptacle 450.

According to an embodiment, in the operation method of the electronic device 501, the first grip sensor 411 may be disposed on the second printed circuit board 492 and connected to the first antenna 497.

According to an embodiment, the operation method of the electronic device 501 may include identifying whether a user is gripping the side part of the electronic device 501, based on a third sensing value corresponding to the amount of change in capacitance of the coaxial cable 400 obtained through the first grip sensor 411.

According to an embodiment, the operation method of the electronic device 501 may include identifying whether a user is gripping the lower part of the electronic device 501, based on a fourth sensing value corresponding to the amount of change in capacitance of the first antenna 497 obtained through the first grip sensor 411.

According to an embodiment, in the operation method of the electronic device 501, the electronic device may include a switch circuit 432 configured to connect the first antenna 497 to at least one capacitor or inductor.

According to an embodiment, the operation method of the electronic device 501 may include controlling the switch circuit 432 to adjust a resonant frequency of the first antenna 497, based on the third sensing value and the fourth sensing value.

According to an embodiment, the operation method of the electronic device 401 or 501 may include adjusting a transmission power of the RF signal, based on the amount of change in capacitance.

According to an embodiment, in a non-transitory recording medium, the electronic device 401 or 501 may include a first printed circuit board 491, a second printed circuit board 492 disposed spaced apart from the first printed circuit board 491, a coaxial cable connecting the first printed circuit board 491 and the second printed circuit board 492 to transmit an RF signal, and a first grip sensor 411 connected to a shield part included in the coaxial cable.

According to an embodiment, the non-transitory recording medium may store at least one instruction capable of performing an operation of identifying the amount of change in capacitance of the shield part 410 through the first grip sensor 411.

According to an embodiment, the non-transitory recording medium may store at least one instruction capable of performing an operation of identifying whether a user is gripping the electronic device 401 or 501, based on the amount of change in capacitance of the shield part 410.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101, 401, and 501). For example, a processor (e.g., the processor 120, 420) of the machine (e.g., the electronic device 101, 401, and 501) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101 of FIG 1; 401 of FIG 4a; 501 of FIG 5a) comprising:
a first printed circuit board (491 of FIG 4a; 491 of FIG 5a),
a second printed circuit board (492 of FIG 4a; 492 of FIG 5a) spaced apart from the first printed circuit board,
a coaxial cable (400 of FIG 4a; 400 of FIG 5a) connecting the first printed circuit board and the second printed circuit board to transmit an RF signal,
a first grip sensor (411 of FIG 4a; 411 of FIG 5a) connected to a shield part (410 of FIG 4b; 410 of FIG 5b) included in the coaxial cable,
memory (130) storing instructions, and
at least one processor (420 of FIG 4a; 420 of FIG 5a),
wherein the instructions, when executed by the at least one processor (420 of FIG 4a; 420 of FIG 5a), cause the electronic device (101 of FIG 1; 401 of FIG 4a; 501 of FIG 5a) to
identify, through the first grip sensor, an amount of change in capacitance of the shield part.

2. The electronic device of claim 1, further comprising:
a first receptacle (440 of FIG 4b; 440 of FIG 5b) disposed on the first printed circuit board and connected to one end of the coaxial cable;
a second receptacle (450 of FIG 4b; 450 of FIG 5b) disposed on the second printed circuit board and connected to the other end of the coaxial cable;
a first capacitor (470 of FIG 4b; 470 of FIG 5b) disposed between the first receptacle and a ground of the first printed circuit board; and
a second capacitor (480 of FIG 4b; 480 of FIG 5b) disposed between the second receptacle and a ground of the second printed circuit board.

3. The electronic device of claim 1 or claim 2, further comprising:
a first antenna (497 of FIG 4a) connected to the second receptacle; and
a second grip sensor (412 of FIG 4a) disposed on the second printed circuit board and connected to the first antenna.

4. The electronic device of any one of claim 1 to claim 3, wherein the first grip sensor is disposed on the first printed circuit board and connected to the first receptacle and the first capacitor.

5. The electronic device of any one of claim 1 to claim 4, wherein the instructions cause the electronic device to:
based on a first sensing value corresponding to the amount of change in the capacitance of the shield part obtained through the first grip sensor, identify whether a side part of the electronic device is gripped by a user, and
based on a second sensing value corresponding to an amount of change in capacitance of the first antenna obtained through the second grip sensor, identify whether a lower part of the electronic device is gripped by the user.

6. The electronic device of any one of claim 1 to claim 5, further comprising,
a switch circuit (432 of FIG 4a) configured to connect the first antenna to at least one of a capacitor or an inductor,
wherein the instructions cause the electronic device to,
based on the first sensing value and the second sensing value, control the switch circuit to adjust a resonant frequency of the first antenna.

7. The electronic device of any one of claim 1 to claim 6, further comprising,
a first antenna (497 of FIG 5a) connected to the second receptacle,
wherein the first grip sensor is disposed on the second printed circuit board and connected to the first antenna.

8. The electronic device of any one of claim 1 to claim 7, wherein the instructions cause the electronic device to:
based on a third sensing value corresponding to the amount of change in the capacitance of the shield part obtained through the first grip sensor, identify whether a side part of the electronic device is gripped, and
based on a fourth sensing value corresponding to an amount of change in capacitance of the first antenna obtained through the first grip sensor, identify whether a lower part of the electronic device is gripped.

9. The electronic device of any one of claim 1 to claim 8, wherein the instructions cause the electronic device to,
based on the amount of change in capacitance, control transmission power of the RF signal.

10. The electronic device of any one of claim 1 to claim 9, wherein the instructions cause the electronic device to,
based on the first sensed value and the second sensed value, identify whether the electronic device is gripped by a user's left hand or right hand.

11. An operation method of an electronic device (101 in FIG. 1; 401 in FIG. 4A; 501 in FIG. 5A) comprising a first printed circuit board (491 in FIG. 4A; 491 in FIG. 5A), a second printed circuit board (492 in FIG. 4A; 492 in FIG. 5A) disposed spaced apart from the first printed circuit board, a coaxial cable (400 in FIG. 4B; 400 in FIG. 5B) configured to connect the first printed circuit board and the second printed circuit board and transmit an RF signal, and a first grip sensor (411 in FIG. 4A; 411 in FIG. 5A) connected to a shield part (410 in FIG. 4B; 410 in FIG. 5B) included in the coaxial cable 400,
the method comprising
identifying an amount of change in capacitance of the shield part through the first grip sensor.

12. The operation method of an electronic device of claim 11,
wherein the electronic device further comprises:
a first receptacle (440 in FIG. 4B; 440 in FIG. 5B) disposed on the first printed circuit board and connected to one end of the coaxial cable;
a second receptacle (450 in FIG. 4B; 450 in FIG. 5B) disposed on the second printed circuit board and connected to the other end of the coaxial cable;
a first capacitor (470 in FIG. 4B; 470 in FIG. 5B) disposed between the first receptacle and a ground of the first printed circuit board; and
a second capacitor (480 in FIG. 4B; 480 in FIG. 5B) disposed between the second receptacle and a ground of the second printed circuit board.

13. The operation method of an electronic device of claim 11 or 12,
wherein the electronic device further comprises:
a first antenna (497 in FIG. 4B) connected to the second receptacle; and
a second grip sensor (412 in FIG. 4A) disposed on the second printed circuit board and connected to the first antenna.

14. The operation method of an electronic device of any one of claims 11 to 13,
wherein the first grip sensor is disposed on the first printed circuit board and connected to the first receptacle and the first capacitor.

15. A non-transitory recording medium,
wherein an electronic device (101 in FIG. 1; 401 in FIG. 4A; 501 in FIG. 5A) comprises a first printed circuit board (491 in FIG. 4A; 491 in FIG. 5A), a second printed circuit board (492 in FIG. 4A; 492 in FIG. 5A) disposed spaced apart from the first printed circuit board, a coaxial cable (400 in FIG. 4B; 400 in FIG. 5B) configured to connect the first printed circuit board and the second printed circuit board and transmit an RF signal, and a first grip sensor connected to a shield part (410 in FIG. 4B; 410 in FIG. 5B) included in the coaxial cable 400,
the non-transitory recording medium storing
at least one instruction capable of identifying an amount of change in capacitance of the shield part through the first grip sensor.
